(19) Europäisches Patentamt
European Patent Office
Office européen des brevets

(11) **EP 2 841 880 B1**

(12) **EUROPÄISCHE PATENTSCHRIFT**

(45) Veröffentlichungstag und Bekanntmachung des Hinweises auf die Patenterteilung:
**18.05.2016 Patentblatt 2016/20**

(21) Anmeldenummer: **13711316.3**

(22) Anmeldetag: **06.03.2013**

(51) Int Cl.:
*G01D 9/00* (2006.01)       *H03M 1/12* (2006.01)

(86) Internationale Anmeldenummer:
**PCT/EP2013/054505**

(87) Internationale Veröffentlichungsnummer:
**WO 2013/159972 (31.10.2013 Gazette 2013/44)**

(54) **SENSOR MIT ZEITSTEMPEL FÜR ABTAST-ZEITPUNKT**

SENSOR WITH TIMESTAMP FOR SAMPLING TIME

CAPTEUR AVEC HORODATAGE POUR TEMPS D'ÉCHANTILLONNAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.04.2012 DE 102012207026**

(43) Veröffentlichungstag der Anmeldung:
**04.03.2015 Patentblatt 2015/10**

(73) Patentinhaber: **Robert Bosch GmbH**
**70442 Stuttgart (DE)**

(72) Erfinder:
• **LAMMEL, Gerhard**
  **72070 Tuebingen (DE)**
• **DORSCH, Rainer**
  **72135 Dettenhausen (DE)**
• **CLAUS, Thomas**
  **72072 Tuebingen (DE)**

(56) Entgegenhaltungen:
**EP-A2- 1 742 187     WO-A1-2010/056246**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 841 880 B1

**Beschreibung**

Stand der Technik

Die Erfindung betrifft einen Sensor mit einem Erfassungselement, einem analogen Frontend und einem digitalen Backend; wobei das digitale Backend über eine digitale Schnittstelle mit einer Steuereinheit zu verbinden ist, wobei der Sensor abgetastete Daten in dem digitalen Backend bereitstellt.

Die Erfindung betrifft außerdem ein Verfahren zum Vergeben einer Zeitinformation an abgetastete Messdaten eines Sensors.

WO 2010/056246 zeigt einen Transmitter, in dem Sensordaten mit einer relativen Zeitinformation abgespeichert werden, um daraus später die Echtzeit für die Sensordaten berechnen zu können. EP1742187 zeigt ein Steuergerät, in welchem Sensorwerte im Intervall zwischen zwei Auslesezeitpunkten interpoliert werden. Hierfür wird ein Zähler verwendet.

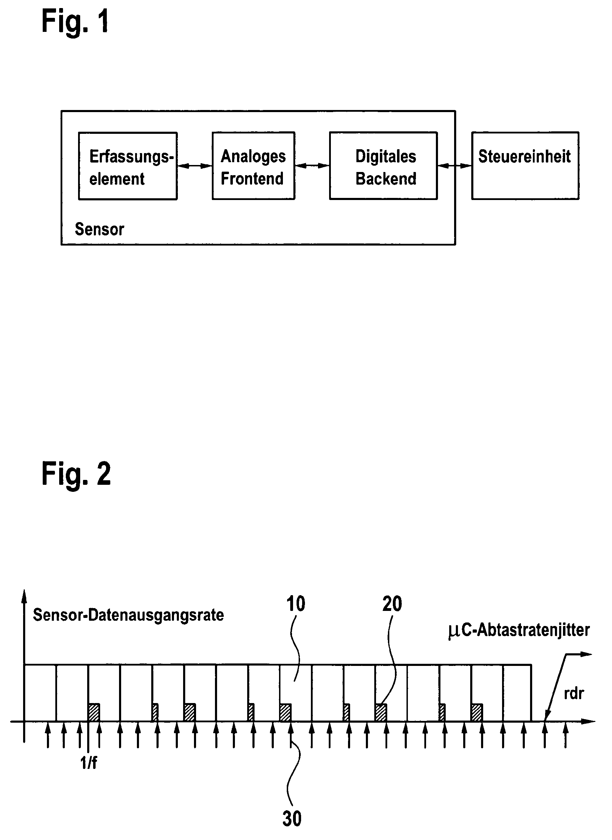

US-7382780 B1 beschreibt die retrospektive Zeitsynchronisation unter Verwendung von Abtastwertzählern und eines Echtzeit-Takts sowie die Sammlung von Daten in Rahmen. Sie betrifft nicht Sub-Abtastintervall-Zeiten. Ein Sensor besteht typischerweise aus einem Erfassungselement, einem analogen Frontend und einem digitalen Backend, wie in Fig. 1 zu sehen ist. Das Erfassungselement setzt die zu messende physikalische Größe in ein Analogsignal um und das analoge Frontend steuert das Erfassungselement und verarbeitet das Analogsignal und setzt es in ein Digitalsignal um. Das digitale Backend führt z.B. Datenfilterung, Ereigniserzeugung und Steuerung des analogen Frontend durch. Ein oder mehrere Sensoren sind durch eine digitale Schnittstelle des digitalen Sensor-Backend mit einer Steuereinheit verbunden, z.B einem Anwendungsprozessor in einem Smartphone oder Internet-Tablet, einem dedizierten Mikrocontroller (μC) oder einer beliebigen anderen Implementierung einer Steuereinheit in Hardware oder Software. Der Sensor tastet Sensordaten mit einer konfigurierbaren Ausgangsdatenrate odr ab und speichert die verarbeiteten Sensordatenabtastwerte in dem digitalen Backend. Gegebenenfalls kann das digitale Backend einen FIFO-Speicher zur Sensordatenspeicherung enthalten. Die Steuereinheit liest die Sensordaten über die digitale Schnittstelle aus dem digitalen Backend. Die Sensoren verfügen über keinen Begriff der globalen Zeit, d.h beim Verarbeiten der Sensordaten in der Steuereinheit wird typischerweise angenommen, dass die Zeit, zu der die Steuereinheit die Sensordaten ausliest, mit der Zeit identisch ist, zu der die Sensordaten abgetastet wurden.

Sensoren implementieren typischerweise Filterfunktionen, z.B ein Tiefpassfilter, mit einer bestimmten Bandbreitengrenze.

Die Ausgangsdatenrate des Sensors hängt oft von Umgebungsparametern wie Temperatur ab. Bei Änderungen an diesen Parametern sind Schwankungen von 10% der Ausgangsdatenrate nicht unüblich. Die Steuereinheit mit einer unabhängigen und typischerweise genaueren Zeitreferenz liest die Daten asynchron aus dem Sensor mit einer Auslesedatenrate *rdr* wie in Fig. 2 gezeigt.

Jeder Abtastintervallkasten (10) gibt einen neuen Sensordatenabtastwert an, der in dem digitalen Teil gespeichert wird, die Pfeile unten geben die Auslesungen (30) der Steuereinheit aus dem Sensor an, die in diesem Beispiel häufiger sind als der Sensor Ausgangsdaten erzeugt. Da typischerweise angenommen wird, dass die Sensordaten-Abtastzeit und die Sensordaten-Auslesezeit identisch sind, bedeutet dies, dass die Verzögerung zwischen der Erzeugung von Ausgangsdaten und der Auslesung nicht berücksichtigt wird. Durch diese Annahme wird ein Zeitjitter eingeführt, das durch die Jitterkästen (20) angegeben ist. Das durch den beschriebenen Mechanismus hinzugefügte mittlere Jitter wird gegeben durch

$$\text{Jitter}_{average}=\text{MIN}(1/odr,1/rdr)/2.$$

Oft werden Daten von mehr als einem Sensor verwendet, um Fusionsdaten, z.B. Orientierung im Raum oder Position einer mobilen Einrichtung, zu berechnen. Diese Techniken werden oft in Trägheitsmesseinheiten (IMUs) verwendet. Jitter verschlechtert die Genauigkeit der berechneten Daten.

Zusätzlich zu der Fehlanpassung zwischen odr und *rdr* kommt Latenz dazu, die sich auf bestimmte Anwendungen, z.B. Echtzeit-Spielanwendungen, auswirken kann.

Es gibt drei bekannte Lösungen für das oben beschriebene Problem. Das Vergrößern der Auslesedatenrate *rdr* verkleinert das mittlere Jitter gemäß der Gleichung für Jitter$_{average}$. Das Vergrößern der Ausgangsdatenrate odr verkleinert das mittlere Jitter gemäß der Gleichung für Jitter$_{average}$. Das Vergrößern der Ausgangsdatenrate wird durch derzeitige Sensoren, z.B. den Dreiachsen-Beschleunigungssensor BMA255 Digital, unterstützt. Das Triggern von Auslesungen durch Interrupts ist eine andere Technik, die von dem Sensor erfordern soll, ein Interrupt zu der Steuereinheit zu senden, wenn neue Daten verfügbar sind. Dies leitet dann das Auslesen von Daten aus dem Sensor ein.

Diese bekannten Lösungen können jedoch einige Nachteile umfassen. Das Vergrößern der Auslesedatenrate *rdr* vergrößert die Arbeitslast für die Steuereinheit. Falls die Steuereinheit in Software implementiert ist und der ausführende Prozessor nur niedrige Auslastung aufweist, vergrößert diese Lösung die Anzahl der Übergänge des Ausführungsprozessors von inaktiv in ein-Zustände, wodurch der Stromverbrauch signifikant vergrößert wird.

Das Vergrößern der Ausgangsdatenrate *odr* bedeutet, dass, wenn die Abtastrate vergrößert wird, dadurch Rauschen auf den Sensordaten vergrößert wird. Wenn nur die Ausgangsdatenrate unabhängig von der Bandbreite des Tiefpassfilters geändert wird, wird die Implementierung des digitalen Backend komplexer. Dadurch erhöht sich die erforderliche Siliziumfläche und der Stromverbrauch des digitalen Backend. Die Kosten für die Sensorhardware und den Betrieb des Sensors nehmen somit zu.

Das Triggern von Auslesungen durch Interrupts erfordert separate Leitungen für das Interrupt-Signal zusätzlich zu typischen Schnittstellen wie I2C, wodurch Kosten hinzukommen. Zusätzlich ist das Verarbeiten von Interrupts durch Software auf der Steuereinheit nicht sehr effizient, da ein Interrupt einen Kontextwechsel in dem Prozessor erfordert. Dies wirkt sich auf Cache-Hit-Verhältnisse in dem Prozessor und ähnliche Leistungsfähigkeitsparameter aus. Wenn viele Sensoren mit einem Prozessor verbunden sind, skaliert sich diese Lösung nicht gut. Zusätzlich werden bei vielen modernen mobilen Plattformen Interrupts nicht unmittelbar versorgt, und somit behandelt die Lösung das Problem nur teilweise.

Offenbarung der Erfindung

Aufgabe der Erfindung

Die Erfindung hat die Aufgabe einen Sensor zu schaffen, dessen Messdaten möglichst präzise einem Messzeitpunkt zugeordnet werden können. Die Erfindung hat auch die Aufgabe ein Verfahren zur Zuordnung von Messdaten eines Sensors zu einem Messzeitpunkt zu schaffen.

Zeichnung

Fig. 1 zeigt einen vorbekannten Sensor und eine Steuereinheit.
Fig. 2 zeigt eine vorbekannte Sensorausgangsdatenrate als Funktion der Lesedatenrate einer Steuereinheit.
Fig. 3 zeigt einen Abtasttimer eines Sensors gemäß einer ersten Ausführungsform der Erfindung.
Fig. 4 zeigt einen Sensortimer, der aus einem Abtastzähler und einem Abtasttimer eines Sensors besteht, gemäß einer zweiten Ausführungsform der Erfindung.
Fig. 5 zeigt zwei Sensoren, die jeweils ihre Abtastwerte in einem FIFO-Speicher mit etwas unterschiedlicher Abtastrate speichern.
Fig. 6 zeigt einen Sensor gemäß der Erfindung und eine Steuereinheit.
Fig. 7 zeigt ein Verfahren zur Vermeidung von Jitter beim Datenauslesen des Sensors.
Fig. 8 zeigt ein Verfahren zur Echt-Ausgabedatenratenschätzung des Sensors.
Fig. 9 zeigt ein Verfahren zum Verringern von Latenz beim Beschaffen von Daten aus dem Sensor.
Fig. 10 zeigt ein Verfahren zum Verringern von Jitter unter Verwendung eines FIFO-Speichers in dem Sensor.

Beschreibung der Erfindung anhand von Ausführungsbeispielen

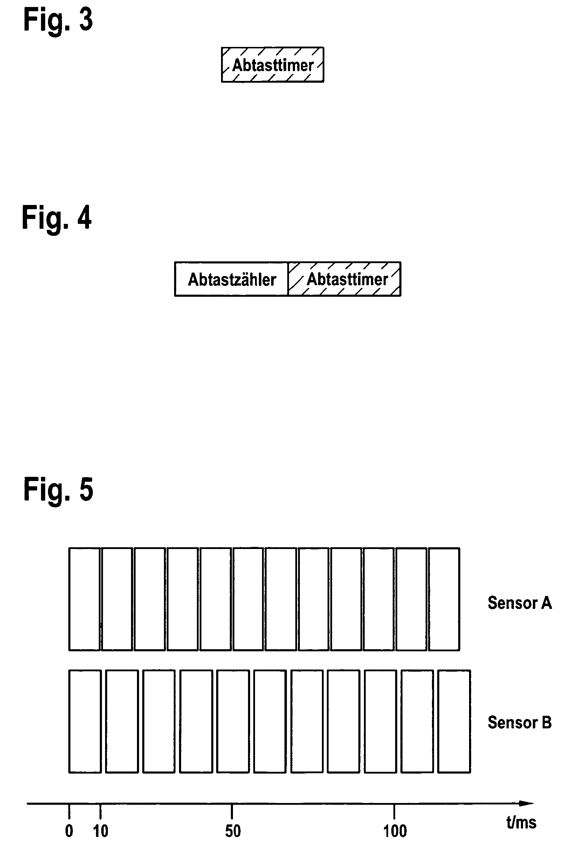

Fig. 3 zeigt einen Abtasttimer eines Sensors gemäß einer ersten Ausführungsform der Erfindung. Bei einer ersten Ausführungsform der Erfindung wird ein Register zu dem in Fig. 1 beschriebenen Sensor hinzugefügt. Das Register enthält das Alter der Sensordaten und wird durch das digitale Backend des Sensors aktualisiert. Das zusätzliche Register erlaubt es der Steuereinheit, das Alter der Sensordaten seit ihrer Erzeugung auszulesen. Dies kann als separater Zähler realisiert werden, oder ein existierender Zähler kann wiederverwendet werden, wodurch die Datenabtastung gesteuert wird. Der Zähler wird nach neuer Datenabtastwerterzeugung zurückgesetzt und läuft weiter, bis Daten durch die Steuereinheit ausgelesen werden, oder länger. Der *"Abtasttimer"* ist der Wert des Abtastzeitregisters, normiert auf eine *Abtastperiode.* Die *Abtastperiode* wird durch 1/*odr* gegeben. Wenn man beispielsweise eine Abtastperiode von 10 ms hat, hätte, wenn der Datenabtastwert zum Zeitpunkt des Auslesens 3 ms alt ist, der *Abtasttimer* den Wert 0,3 *Abtastperioden* (zum Auslesezeitpunkt). Dadurch kann Jitter verringert werden.

Das Lesen des Abtasttimers erlaubt es der Steuereinheit, zu bestimmen, wie alt die Daten zum Zeitpunkt des Auslesens aus dem Sensor sind. Im Idealfall kann dieses Abtasttimerregister atomisch (in einem Datenblock ohne Unterbrechung) mit den Sensordaten ausgelesen werden. Die Steuereinheit kann mit Bezug auf ihre Steuersystemzeit den Zeitpunkt in der Vergangenheit rekonstruieren, zu dem die Sensordaten tatsächlich erzeugt wurden. Wenn sich mehr als ein Sensor in einem System befindet, z.B. ein Beschleunigungsmesser, ein Gierratensensor und ein Magnetometer, sind synchronisierte Sensordaten für Sensorfusionsalgorithmen wichtig. Verringertes Jitter erlaubt bessere Sensordatensynchronisation. Dadurch vergrößert sich die Leistungsfähigkeit des Sensorfusionsalgorithmus.

Fig. 4 zeigt einen *Sensortimer,* der aus einem *Abtastzähler* und einem *Abtasttimer* eines Sensors besteht, gemäß einer zweiten Ausführungsform der Erfindung. Bei einer zweiten Ausführungsform der Erfindung wird ein Register zu dem in Fig. 3 beschriebenen Sensor hinzugefügt. Wenn zusätzlich zu dem *Abtasttimer* ein *Abtastzähler* vorliegt, soll dies als *Sensorzeit* bezeichnet werden. Man kann damit den Sensortakt als Funktion des Steuersystemtakts messen. Die Steuereinheit kann die *Sensorzeit* an zwei Zeitpunkten auslesen und die reale Ausgangsdatenrate *rodr* berechnen. Die reale Ausgangsdatenrate erlaubt, vorherzusagen, wann die nächsten erzeugten Sensordaten verfügbar sind, was zur Verringerung von Latenz beim Lesen von Sensordaten verwendet werden kann, ohne die Leistung signifikant zu vergrößern. Zusätzlich erlaubt es die Schätzung der Datenerzeugungszeiten der Datenrahmen im FIFO, wodurch widerum wiederum bessere Datensynchronisation ermöglicht wird.

Fig. 5 zeigt zwei Sensoren, die jeweils ihre Abtastwerte in einem FIFO-Speicher mit etwas unterschiedlicher Abtastrate speichern, obwohl die konfigurierte Ausgangsdatenrate für die Sensoren identisch sein könnte. Die Figur zeigt in einem Beispiel das Problem des asynchronen Abtastens zweier Sensoren. Im selben Moment mit der Abtastung beginnend speichert in einem gegebenen Zeitraum Sensor A 12 Abtastwerte in einem FIFO, während Sensor B nur 11 Abtastwerte speichert. Ohne einen *Sensortimer* werden, wenn die Abtastzeit auf der Basis der Auslesezeit und des konfigurierten ODR berechnet wird, die Abtastwerte in dem FIFO in diesem Beispiel um mehr als eine Abtastperiode fehlausgerichtet.

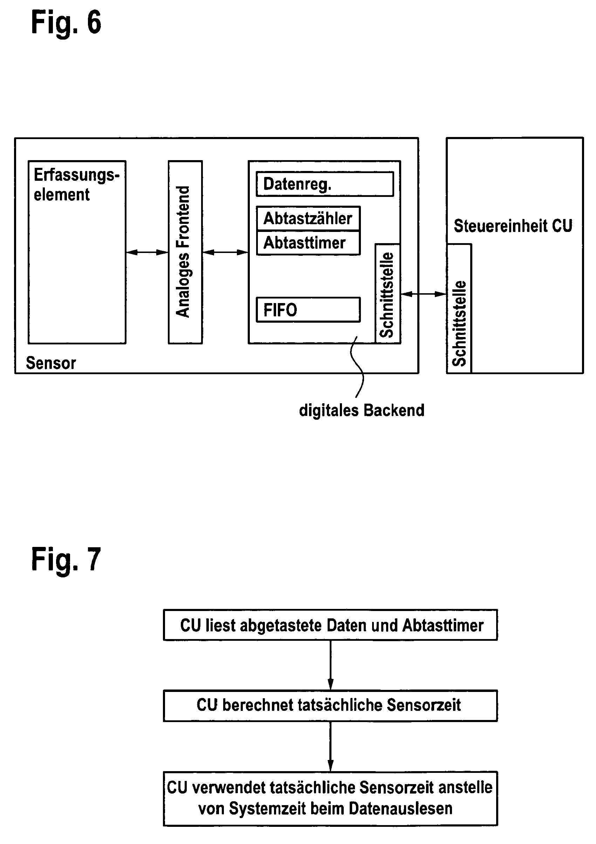

Fig. 6 zeigt einen Sensor gemäß der Erfindung und eine Steuereinheit. Zusätzlich zu dem vorbekannten Sensor von Fig. 1 sind ein Datenregister für Sensordaten, ein Abtasttimer und ein Abtastzähler in dem digitalen Backend vorgesehen. Um gemessene Daten, Abtastzähler und Abtastzeit auszulesen, ist die Steuereinheit CU über Schnittstelle mit dem Sensor verbunden. Zusätzlich kann ein FIFO-Speicher in dem digitalen Backend vorgesehen sein. In diesem FIFO können Werte von Sensordaten gespeichert werden.

Ein anderer Aspekt der Erfindung ist ein Verfahren zur Jitterverringerung beim Beschaffen von Daten von dem Sensor. Fig. 7 zeigt ein Verfahren zur Vermeidung von Jitter beim Datenauslesen des Sensors. Die Steuereinheit liest die Sensordaten und die *Sensorzeit* aus. Der Abtasttimer-Teil des Sensorzeit-Inhalts ist direkt das in den Jitterkästen 20 in Fig. 2 gezeigte Jitter. Die Steuereinheit berechnet die Datenerzeugungszeit, d.h. die tatsächliche Sensorzeit, durch Subtrahieren von *Abtasttimer \* Abtastperiode* von ihrer aktuellen Systemzeit. Die Steuereinheit CU verwendet dann tatsächliche Sensorzeit anstelle der Systemzeit als einen Zeitstempel für die beim Datenauslesen bereitgestellten abgetasteten Daten.

$$\text{Tatsächliche Sensordatenzeit} = \text{Systemzeit beim Datenauslesen} - Abtasttimer * Abtastperiode$$

Als eine Erweiterung können eine zusätzliche Verzögerung für das Abtasten (z.B. in dem Sensor-Frontend), Datenverarbeitung (z.B. in dem Sensor-Backend) und Lesen der Daten subtrahiert werden.

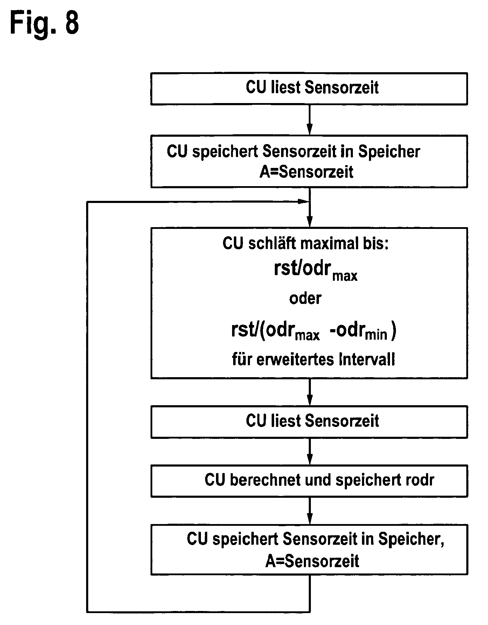

Ein anderer Aspekt der Erfindung ist ein Verfahren zur Echt-Ausgangsdatenratenschätzung beim Beschaffen von Daten aus dem Sensor wie in Fig. 8 gezeigt. Es wird angenommen, dass die Sensorzeit atomisch ausgelesen wird, d.h. in einer Operation auf der digitalen Schnittstelle darf sich die Sensorzeit während der Leseoperation nicht ändern, z.B. muss der Abtastzähler mit dem Abtasttimer kompatibel sein.

Implementierungsbeispiel:

Das *Sensorzeit*-Register hat einen Bereich *rst*

$$Rst <= 2^{\text{bit des Abtastzählers}}$$

Die maximal mögliche Ausgangsdatenrate ist $odr_{max}$

Ein potentieller Überlauf kann korrigiert werden, wenn die Sensorzeit zum Zeitpunkt *t1* und *t2* mit

$$t2 < t1 + rst/odr_{max}$$

ausgelesen wird. Die reale Ausgangsdatenrate *rodr* (z.B. in Einheiten Abtastwerte/s) kann unter Verwendung von

$$rodr = \mathrm{mod}(\text{Sensorzeit}(t2) - \text{Sensorzeit}(t1), rst)/(t2\text{-}t1)$$

geschätzt werden, wobei die modulo-Operation von Knuth, Donald E, The Art of Computer Programming, Addison-Wesley, 1972, definiert wird.

Anwendungen der *rodr* sind z.B. Verringern von Latenz oder Verringern des Jitter, wenn FIFOs verwendet werden, bevor die Steuereinheit die Daten erhält.

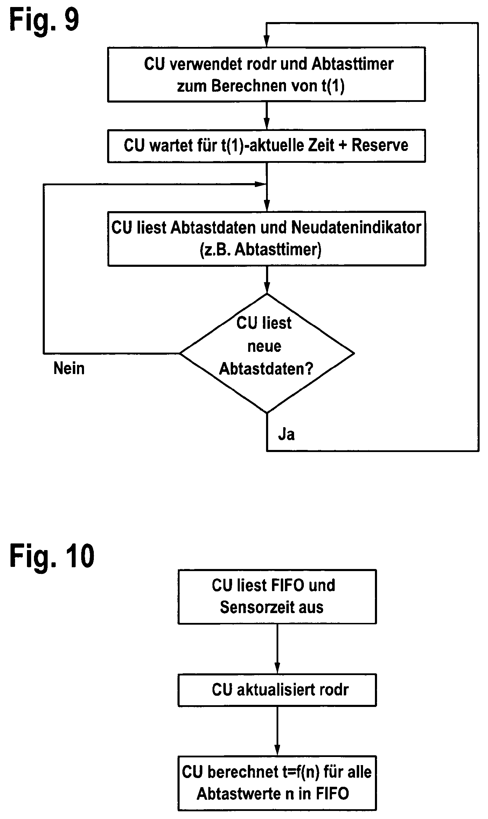

Ein anderer Aspekt der Erfindung ist ein Verfahren zum Verringern der Latenz beim Beschaffen von Daten aus dem Sensor wie in Fig. 9 gezeigt.

Die *rodr* kann dann verwendet werden, um die zukünftigen Zeiten $t(n)$ zu berechnen, zu denen die nächsten n Abtastwerte für die Steuereinheit zum Abruf aus dem Sensor bereit sind,

$$t(n) = t2 + (n - \text{Abtasttimer}(t2)/rodr$$

$$n >= 1...$$

Dadurch kann die Steuereinheit vorhersagen, wann die nächsten Daten erzeugt werden, und sie mit geringer Latenz abrufen, unmittelbar nachdem Daten in dem Sensor verfügbar sind.

Ein anderer Aspekt der Erfindung ist ein Verfahren zum Verringern von Jitter unter Verwendung von FIFO-Speicher in dem Sensor wie in Fig. 10 gezeigt. Die *rodr* kann verwendet werden, um die vergangenen Zeiten $tf(n)$ zu berechnen, zu denen der $n$te Rahmen in dem FI FO erzeugt wurde.

$$tf(n) = t2 - \text{Abtasttimer}(t2) + n - 1)/rodr$$

Wenn die odr anstelle der *rodr* verwendet wird, entsteht ein Fehler von 5% in der *odr* in einem FIFO mit 10 Elementen in 50% eines Abtastperioden-Jitter. Stattdessen *rodr* zu verwenden, löst dieses Problem.

Ein anderer Aspekt der Erfindung ist ein Verfahren zum Erweitern des Messintervalls des Sensors wie in Fig. 8 gezeigt.

Die Beschränkung des Messintervalls auf

$$rst/odr_{max}$$

kann gelockert werden, wenn die minimal mögliche Ausgangsdatenrate $odr_{min}$ dem Messintervall

$$rst/(odr_{max}\text{-}odr_{min})$$

bekannt ist, wodurch eine eindeutige Korrelation mit der Anzahl der Sensorzeitüberläufe *sto* mit Bezug auf *Sensorzeit*(*t1*) ermöglicht wird,

$$rodr = (\mathrm{mod}(\text{Sensorzeit}(t2) - \text{Sensorzeit}(t1), rst) + sto * rst)/(t2\text{-}t1)$$

mit

$$sto = \begin{cases} sto_{min} & \text{für } realmod >= stomod_{min} \\ sto_{min}+1 & \text{für } realmod < stomod_{min} \end{cases}$$

dabei ist

$$sto = (t2-t1)*odr_{min}/rst$$

$$stomod_{min} = \mathrm{mod}((t2-t1)*odr_{min},rst)$$

$$realmod = \mathrm{mod}(Sensorzeit(t2) - Sensorzeit(t1),rst)$$

Hier ist $sto_{min}$ die Mindestzahl der Sensorzeit-Überläufe, die auf der minimalen odr basiert. Ein Sensorzeitüberlauf zum Zeitpunkt $t$ wird gegeben, wenn

$$Sensorzeit(t) = Sensorzeit(t1) \text{ ist.}$$

Die maximale Anzahl der Überläufe kann nur um eins größer als die Mindestzahl sein, andernfalls ist die eindeutige Korrelation von Sensorzeitüberläufen mit Sensorzeit nicht mehr möglich. Wenn der modulo-Wert aus den gemessenen Sensorzeitdaten unter dem modulo-Wert des Mindest-odr liegt, muss es einen zusätzlichen Sensorzeitüberlauf geben.

**Patentansprüche**

1. Sensor, der ein Erfassungselement, ein analoges Frontend und ein digitales Backend umfasst; wobei das digitale Backend über eine digitale Schnittstelle mit einer Steuereinheit zu verbinden ist, wobei der Sensor abgetastete Daten in dem digitalen Backend bereitstellt, wobei der Sensor Mittel zum Bereitstellen von Zeitinformationen der abgetasteten Daten in dem digitalen Backend enthält, auf die durch die digitale Schnittstelle durch die Steuereinheit zugegriffen werden kann,
   **dadurch gekennzeichnet, dass** die Mittel zum Bereitstellen von Zeitinformationen ein Abtasttimerregister umfassen, <u>welches das Alter der Sensordaten normiert auf eine Abtastperiode enthält.</u>

2. Sensor nach Anspruch 1, **dadurch gekennzeichnet, dass** die Mittel zum Bereitstellen von Zeitinformationen ein Abtastzählerregister umfassen.

3. Sensor nach Anspruch 1 oder 2, **dadurch gekennzeichnet, dass** das Abtastzählerregister und/oder das Abtasttimerregister in einer atomischen Operation mit den abgetasteten Daten ausgelesen werden können.

4. Sensor nach einem der vorhergehenden Ansprüche, **dadurch gekennzeichnet, dass** das digitale Backend einen FIFO-Speicher umfasst.

5. Verfahren zum Zuordnen einer Zeitinformation zu abgetasteten Messdaten eines Sensors, **gekennzeichnet durch** die folgenden Schritte:

   a) Bereitstellen eines Sensors nach einem der vorhergehenden Ansprüche 1-4.
   b) Bereitstellen einer Steuereinheit, die über eine digitale Schnittstelle mit dem Sensor verbunden ist
   c) Zugreifen auf die abgetasteten Daten des Sensors **durch** die Steuereinheit
   d) Zugreifen auf die <u>im Abtasttimerregister vorliegende</u> Zeitinformation der abgetasteten Daten des Sensors **durch** die Steuereinheit
   e) Berechnen eines Zeitstempels **durch** die Steuereinheit
   f) Zuordnen des Zeitstempels zu den abgetasteten Daten **durch** die Steuereinheit.

6. Verfahren nach Anspruch 5, **dadurch gekennzeichnet, dass** die Steuereinheit dafür ausgelegt ist, die Datenausleselatenz durch Lesen der abgetasteten Daten, wenn eine vorhergesagte Abtastzeit erreicht ist, zu verringern; wobei das Verfahren <u>einen ersten Zeitstempel t(1)</u> verwendet, um die Zeit vorherzusagen, zu der die nächsten abgetasteten Daten in dem digitalen Backend bereitgestellt werden.

7. Verfahren nach Anspruch 5, **dadurch gekennzeichnet, dass** die Steuereinheit dafür ausgelegt ist, Jitter der Zeitstempel zu verringern, wobei die Steuereinheit das Abtasttimerregister und/oder das Abtastzählerregister verwendet, um eine tatsächliche Abtastzeit mit einer Sub-Abtastauflösung zu berechnen.

8. Verfahren nach Anspruch 7, **dadurch gekennzeichnet, dass** ein Sensor nach Anspruch 4 bereitgestellt wird und die Zeitstempel t unter Verwendung von t=f(n) für die Abtastwerte 1 ... n in dem FIFO berechnet werden.

9. Sensorsystem, das einen Sensor nach einem der Ansprüche 1 bis 4 und eine Steuereinheit, die mit dem Sensor verbunden ist, umfasst.

**Claims**

1. Sensor comprising a sensing element, an analog frontend, and a digital backend; with the digital backend to be connected to a control unit via a digital interface, wherein the sensor provides sampled data in the digital backend, wherein the sensor contains means for providing time information of the sampled data in the digital backend, which can be accessed through the digital interface by the control unit, **characterized in that** the means for providing time information include a sample timer register which contains the age of the sensor data normalized to a sampling period.

2. Sensor according to Claim 1, **characterized in that** the means for providing time information include a sample counter register.

3. Sensor according to Claim 1 or 2, **characterized in that** the sample counter register and/or the sample timer register can be read out in one atomic operation with the sampled data.

4. Sensor according to one of the preceeding claims, **characterized in that** the digital backend includes a FIFO memory.

5. Method to assign an item of time information to sampled measurement data of a sensor, **characterized by** the following steps:

   a) providing a sensor according to one of the preceding Claims 1-4,
   b) providing a control unit connected to the sensor via a digital interface
   c) accessing the sampled data of the sensor by the control unit
   d) accessing the time information of the sampled data of the sensor, which information is present in the sample timer register, by the control unit
   e) calculating a time stamp by the control unit
   f) assigning the time stamp to the sampled data by the control unit.

6. Method according to Claim 5, **characterized in that** the control unit is configured to reduce data readout latency by reading the sampled data, when a predicted sampling time is reached; wherein the method uses a first time stamp t(1) to predict the time when the next sampled data are provided in the digital backend.

7. Method according to Claim 5, **characterized in that** the control unit is configured to reduce jitter of the time stamps, wherein the control unit uses the sample timer register and/or the sample counter register to calculate an actual sample time with a subsample resolution.

8. Method according to Claim 7, **characterized in that** a sensor according to Claim 4 is provided and the timestamps t are calculated using t=f(n) for the samples l...n in the FIFO.

9. Sensor system comprising a sensor according to one of the Claims 1 to 4 and a control unit which is connected to the sensor.

**Revendications**

1. Capteur comprenant un élément de détection, un module frontal analogique et un module principal numérique ; dans lequel le module principal numérique est connecté à une unité de commande par l'intermédiaire d'une interface numérique, dans lequel le capteur délivre des données échantillonnées dans le module principal numérique, dans lequel le capteur contient des moyens destinés à fournir, dans le module principal numérique, des données temporelles, concernant les données échantillonnées, auxquelles l'unité de commande peut accéder par l'intermédiaire de l'interface numérique,

**caractérisé en ce que** les moyens destinés à fournir des informations temporelles comprennent un registre de temps d'échantillonnage qui contient l'âge des données de capteur normalisé sur une période d'échantillonnage.

2. Capteur selon la revendication 1, **caractérisé en ce que** les moyens destinés à fournir des informations temporelles comprennent un registre de compteur d'échantillonnage.

3. Capteur selon la revendication 1 ou 2, **caractérisé en ce que** le registre de compteur d'échantillonnage et/ou le registre de temps d'échantillonnage peuvent être lus lors d'une opération automatique avec les données échantillonnées.

4. Capteur selon l'une quelconque des revendications précédentes, **caractérisé en ce que** le module principal numérique comprend une mémoire FIFO.

5. Procédé d'association d'une information temporelle à des données de mesure échantillonnées d'un capteur, **caractérisé par** les étapes consistant à :

a) prévoir un capteur selon l'une quelconque des revendications 1 à 4,
b) prévoir une unité de commande qui est connectée par l'intermédiaire d'une interface numérique au capteur,
c) faire en sorte que l'unité de commande accède aux données échantillonnées du capteur,
d) faire en sorte que l'unité de commande accède aux informations temporelles, présentes dans le registre de temps d'échantillonnage, des données échantillonnées du capteur,
e) faire en sorte que l'unité de commande calcule un marqueur temporel,
f) faire en sorte que l'unité de commande associe le marqueur temporel aux données échantillonnées.

6. Procédé selon la revendication 5, **caractérisé en ce que** l'unité de commande est conçue pour réduire la latence de lecture de données par lecture des données échantillonnées lorsqu'un temps d'échantillonnage prévu a été atteint ; dans lequel le procédé utilise un premier marqueur temporel $t(1)$ afin de prévoir le temps lors duquel les données échantillonnées suivantes sont fournies dans le module principal numérique.

7. Procédé selon la revendication 5, **caractérisé en ce que** l'unité de commande est conçue pour réduire la gigue du marqueur temporel, dans lequel l'unité de commande utilise le registre de temps d'échantillonnage et/ou le registre de compteur d'échantillonnage afin de calculer un temps d'échantillonnage réel avec une résolution inférieure à la résolution d'échantillonnage.

8. Procédé selon la revendication 7, **caractérisé en ce qu'**il est prévu un capteur selon la revendication 4 et **en ce que** les marqueurs temporels $t$ sont calculés en utilisant $t=f(n)$ pour les valeurs d'échantillonnage 1 ... n dans la mémoire FIFO.

9. Système de capteur comprenant un capteur selon l'une quelconque des revendications 1 à 4 et une unité de commande qui est connectée au capteur.

# Fig. 1

```
┌──────────────────────────────────────────────────────────┐
│  ┌─────────────┐   ┌─────────────┐   ┌─────────────┐       │   ┌─────────────┐
│  │ Erfassungs- │◄─►│  Analoges   │◄─►│  Digitales  │◄──────┼──►│ Steuereinheit │
│  │  element    │   │  Frontend   │   │  Backend    │       │   │             │
│  └─────────────┘   └─────────────┘   └─────────────┘       │   └─────────────┘
│  Sensor                                                    │
└──────────────────────────────────────────────────────────┘
```

# Fig. 2

Sensor-Datenausgangsrate    10    20    μC-Abtastratenjitter

rdr

1/f

30

# Fig. 3

Abtasttimer

# Fig. 4

Abtastzähler | Abtasttimer

# Fig. 5

Sensor A

Sensor B

0  10              50              100          t/ms

## Fig. 6

```
┌─────────────────────────────────────────────────────┐   ┌─────────────────────┐
│ ┌──────────────┐   ┌────────┐   ┌──────────────────┐ │   │                     │
│ │ Erfassungs-  │   │        │   │ ┌──────────────┐ │ │   │                     │
│ │ element      │   │        │   │ │  Datenreg.   │ │ │   │  Steuereinheit CU   │
│ │              │   │ Analoges│  │ └──────────────┘ │ │   │                     │
│ │              │◄─►│Frontend│◄─►│ ┌──────────────┐ │S│   │                   S │
│ │              │   │        │   │ │ Abtastzähler │ │c│◄─►│c                  c │
│ │              │   │        │   │ └──────────────┘ │h│   │h                  h │
│ │              │   │        │   │ ┌──────────────┐ │n│   │n                  n │
│ │              │   │        │   │ │ Abtasttimer  │ │i│   │i                  i │
│ │              │   │        │   │ └──────────────┘ │t│   │t                  t │
│ │              │   │        │   │                  │t│   │t                  t │
│ │              │   │        │   │ ┌──────────────┐ │s│   │s                  s │
│ │              │   │        │   │ │    FIFO      │ │t│   │t                  t │
│ │              │   │        │   │ └──────────────┘ │e│   │e                  e │
│ └──────────────┘   └────────┘   └──────────────────┘l│   │l                    │
│ Sensor                                              le│  │le                   │
└─────────────────────────────────────────────────────┘   └─────────────────────┘
                                        digitales Backend
```

digitales Backend

## Fig. 7

```
┌───────────────────────────────────────────────┐
│   CU liest abgetastete Daten und Abtasttimer    │
└───────────────────────────────────────────────┘
                        │
                        ▼
┌───────────────────────────────────────────────┐
│       CU berechnet tatsächliche Sensorzeit      │
└───────────────────────────────────────────────┘
                        │
                        ▼
┌───────────────────────────────────────────────┐
│  CU verwendet tatsächliche Sensorzeit anstelle  │
│     von Systemzeit beim Datenauslesen           │
└───────────────────────────────────────────────┘
```

# Fig. 8

CU liest Sensorzeit

↓

CU speichert Sensorzeit in Speicher
A=Sensorzeit

↓

CU schläft maximal bis:

$$\text{rst/odr}_{max}$$

oder

$$\text{rst/(odr}_{max} - \text{odr}_{min})$$

für erweitertes Intervall

↓

CU liest Sensorzeit

↓

CU berechnet und speichert rodr

↓

CU speichert Sensorzeit in Speicher,
A=Sensorzeit

# Fig. 9

```
CU verwendet rodr und Abtasttimer
zum Berechnen von t(1)
           │
           ▼
CU wartet für t(1)-aktuelle Zeit + Reserve
           │
           ▼
CU liest Abtastdaten und Neudatenindikator
(z.B. Abtasttimer)
           │
           ▼
      CU liest
        neue
     Abtastdaten?
```

Nein

Ja

# Fig. 10

```
CU liest FIFO und
Sensorzeit aus
        │
        ▼
CU aktualisiert rodr
        │
        ▼
CU berechnet t=f(n) für alle
Abtastwerte n in FIFO
```

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2010056246 A
- EP 1742187 A
- US 7382780 B1

**In der Beschreibung aufgeführte Nicht-Patentliteratur**

- **KNUTH ; DONALD E.** The Art of Computer Programming. Addison-Wesley, 1972